Europäisches Patentamt

European Patent Office

Office européen des brevets

(19)

(11)    EP 1 453 196 A1

(12)    **EUROPEAN PATENT APPLICATION**
published in accordance with Art. 158(3) EPC

(43) Date of publication:
**01.09.2004   Bulletin 2004/36**

(51) Int Cl.7: **H03H 7/075**, H03H 7/03

(21) Application number: **02785442.1**

(86) International application number:
**PCT/ES2002/000523**

(22) Date of filing: **12.11.2002**

(87) International publication number:
**WO 2003/049286 (12.06.2003 Gazette 2003/24)**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority:  **03.12.2001  ES 200102688**

(71) Applicant: **Diseno de Sistemas en Silicio S.A.
46980 Paterna (Valencia) (ES)**

(72) Inventors:
 • **GONZALEZ MORENO, José Luis
   E-46950 Xirivella (ES)**
 • **POVEDA LERMA, Antonio
   E-46134 Foyos (ES)**
 • **VIDAL ROS, José Maria
   E-46013 Valencia (ES)**

(74) Representative: **Ungria Lopez, Javier et al
   Avda. Ramon y Cajal, 78
   28043 Madrid (ES)**

(54)    **ANALOG BANDPASS FILTER**

(57)    The invention relates to an analog bandpass filter comprising a plurality of LC ladder circuits (1), the response from which is determined by a passband (fpi, fps) and a rejection band (with limits fri and frs). The inventive filter is characterised in that a series of tank circuits (5) is disposed in parallel to the filter charge, the resonance frequencies of said tank circuits coinciding with the lower (fpi) and upper (fps) cut-off frequency of the pass-band of the filter. Furthermore, the filter comprises a control resistor (Rc) which regulates the effect of the tank circuits on the filter. Said structure can be used to compensate the effect of the real limitations of the LC components (1) in order to adjust the response from the analog bandpass filter created with said components to the response from the ideal bandpass filter.

FIG.3

## Description

### TECHNICAL FIELD OF THE INVENTION

Comprising numerous LC ladder circuits (1) whose response is defined by a pass band ($f_{pi}$ and $f_{ps}$) and a stop band (0 to $f_{ri}$ and $f_{rs}$ to ); characterized in that in parallel with the filter load they include a series of tank circuits (5) whose resonance frequencies coincide with the lower ($f_{pi}$) and upper ($f_{ps}$) cut frequencies of the bandpass filter. Furthermore, it comprises a control resistance ($R_c$) to regulate the effect of the tank circuits on the filter. This structure allows for compensation for the effects of the real limitations of the LC components to adjust the analog bandpass filter created by these components to the response of an ideal bandpass filter.

### OBJECTIVE OF THE INVENTION

The present invention, as described in the title, consists of an analog bandpass filter comprising numerous LC ladder circuits with the objective of compensating for the effect of the limitations, imposed by the real limitations of the analog LC components, that these type of filters present, and all of this to achieve that the filter response approximates the ideal response of a bandpass filter.

### BACKGROUND OF THE INVENTION

The use of bandpass filters in various applications is well known in the state of the art, above all in applications related to telecommunications. A band pass filter is a filter that allows the frequency band situated between the lower pass frequency ($f_{pi}$) and higher pass frequency ($f_{ps}$) of the input signal to pass, while stopping all the other frequency components.

In reality it is not possible to generate such abrupt falls between the band that should pass and that which should be stopped by the filter, and for which a lower stop frequency $f_{ri}$ (with $f_{ri} < f_{pi}$) and an upper stop frequency $f_{rs}$ (with $f_{rs} > f_{ps}$) are defined. The frequencies in the input signal inferior to $f_{ri}$ and superior to $f_{ps}$ will be attenuated according to a design or specification factors. The band pass filters with these characteristics tend to be produced by combining coils and capacitors.

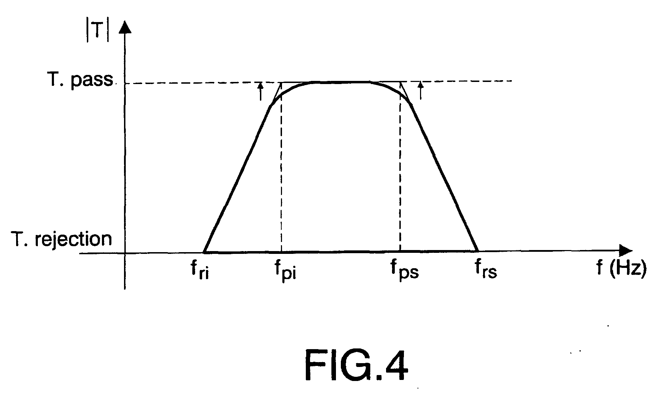

As is known, coils and capacitors do not have an ideal response as they produce certain resistive losses which provokes variations on the frequency and phase of the filter response created with these components, that is to say, they do not generate the desired filtration. The factor that identifies the losses of the component with respect to its ideal value is defined as quality factor Q. The greater the quality factor the smaller the effect of the resistive losses and therefore finally a response of the bandpass filter very close to the ideal is achieved (figure 4).

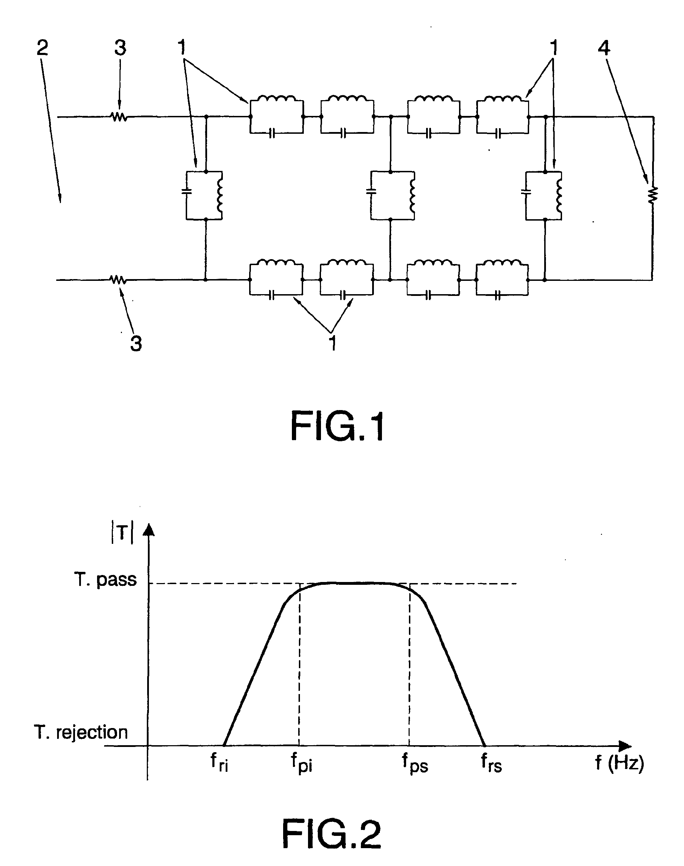

Maximum discrepancy between the real and ideal filters is produced at the extremes of the bandpass filter (figure 2). This circumstance may give rise to the fact that the filter will not be carried out due to the limitation of the factor Q displayed by the real coils (these are the most limiting analog components due to the fact that the capacitors carry a value Q that is sufficiently high so as not to produce distortion in the majority of cases).

Experience shows that to achieve good bandpass filters the components to be used should have a Q that is 20 to 25 times greater than the relation $f_0/f$ of the filter to be produced, where $f_0$ is the central frequency of the filter and f the filter bandwidth. For high frequencies it is necessary to use components with a very high Q factor, and even so, the transition from the stop band to the pass band is conflictive.

### DESCRIPTION OF THE INVENTION

To solve the obstacles previously mentioned, the current invention has developed a new analog bandpass filter that, like conventional filters, comprises numerous LC ladder circuits and is characterized because in parallel with the filter load it includes two tank circuits (LC) whose resonance frequencies coincide with the lower and upper cut frequencies of the bandpass filter. Furthermore, the invention is characterized because it anticipates a control resistance all of which is to compensate for the effect of the quality factor on the real LC components in the implementation of the bandpass filters, so that the bandpass filter response is adjusted to the ideal response.

Therefore, one of the tank circuits has a resonance frequency that corresponds to the lower cut frequency of the pass band and the other shows resonance frequency equal to the upper cut frequency of the pass band of the desired bandpass filter.

The incorporation of the tank circuits produces a distortion in the response of the original filter that compensates for the effect of the real (non ideal) components. This distortion can be controlled by means of the control resistance so that modifying its value adjusts the effects in the extremes of the pass band. For this the control resistance has a value established experimentally to increase or diminish the effect of the tank circuits on the filter response. This value can also be calculated by simulation.

Equally, the LC components of the tank circuits have a value established experimentally or by simulation to adjust the resonance frequency of each tank circuit so as to achieve that the final response of the filter will be more level and to adjust to the ideal response of the bandpass filter.

The following drawings are provided to facilitate a better understanding of the present invention and while forming an integral part of the detailed description and the claims, they offer an illustrative but not limited representation of the object of this invention.

## BRIEF DESCRIPTION OF THE DRAWINGS

Figure 1.- Shows the schematic of a conventional bandpass filter.

Figure 2.- Shows the curve of the real response of a typical conventional analog bandpass filter represented in the previous Figure.

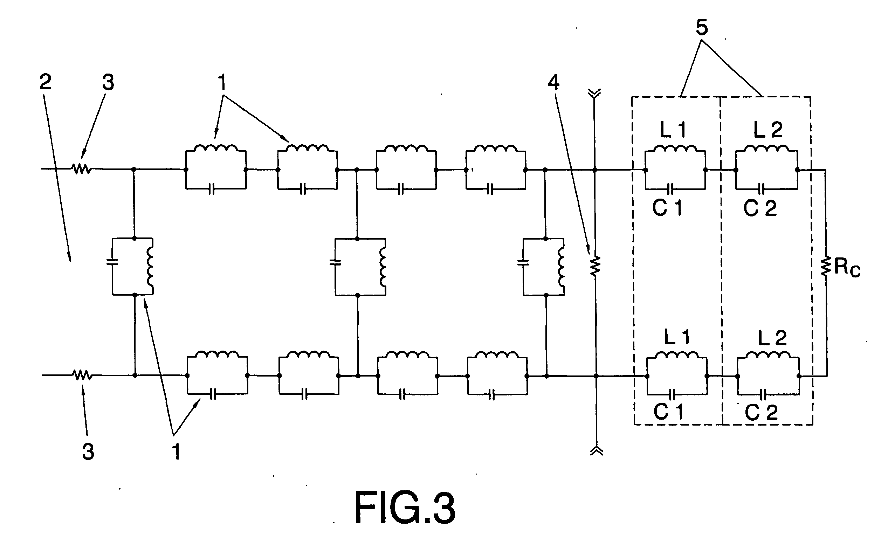

Figure 3.- Shows the schematic of one example carried out of the analog bandpass filter in this invention.

Figure 4.- Shows the real response of the filter of this invention represented in the previous Figure.

## PREFERRED EMBODIMENT OF THE INVENTION

The following is a description of the invention based on the drawings described previously.

Figure 1 shows the schematic of a conventional bandpass filter composed of numerous LC ladder circuits 1 and on exit 2 resistances 3 are foreseen and on exit the filter load is represented by means of the resistance 4 (not described in greater detail because it is conventional).

Figure 2 shows the corresponding drawing of the filter response where T is the module of the ratio between the Laplace transform of the output voltage and the transformation of the input voltage of the filter, that is to say:

$$T(s) = \frac{V_{out}(s)}{V_{in}(s)} \; ;$$

where s is the Laplace transform variable, $f_{pi}$ indicates the lower cut frequency of the pass band, $f_{ps}$ the upper cut frequency of the band pass, $f_{ri}$ the lower frequency of the stop band and $f_{rs}$ the upper frequency of the stop band (as commented on previously in the section entitled BACKGROUND OF THE INVENTION). In the pass band a minimum value for T is defined and in the stop a maximum value for T.

As can be appreciated from Figure 2 the upper part of the filter response shows a curved zone produced by real (non ideal) components. This curve is so far away from the desired ideal response of the bandpass filter that determines that the filter may not be used for the required application.

To be able to achieve an ideal response from the stop band, the invention foresees placing in parallel with the load (4) of the filter, two tank circuits LC (5), so that one of the tank circuits has a resonance frequency equal to $f_{pi}$ and the other a resonance frequency equal to $f_{ps}$.

For this the values L1 and C1 are adjusted so that the circuit resonates at the frequency $f_{pi}$, mentioned previously. These values are calculated by simulation or by a method of trail and error until the real response sufficiently approximates the ideal response being searched for, as shown in figure 4.

In the same way the values L2 and C2 are calculated so that the tank circuit resonates at the frequency $f_{ps}$.

The tank circuits 5 produce a distortion in original filter response in such a way that it compensates for the effect of the real (non ideal) components identified previously. This distortion is controllable by means of a control resistance $R_c$ so that decreasing the resistance diminishes the distortion and vice versa. Equally the value of the control resistance $R_c$ is also calculated by simulation or by a method of trail and error until the desired response is achieved.

## Claims

1. ANALOG BAND PASS FILTER comprising numerous LC ladder circuits (1) whose response is defined by a pass band ($f_{ri}$ and $f_{ps}$) and a stop band (whose limits are $f_{ri}$ and $f_{rs}$); **characterized in that** the LC ladder circuits (1) include in parallel with the filter load, a series of tank circuits (5) whose resonance frequencies coincide with lower ($f_{pi}$) and upper ($f_{ps}$) cut frequencies of the bandpass filter; where furthermore a control resistance $R_c$ is foreseen, all of which is to compensate for effect of a real limitation of LC components by adjusting a real response of the bandpass filter to an ideal response desired.

2. ANALOG BAND PASS FILTER according to Claim 1, **characterized in that** the LC components of the tank circuits (5) have a value selectively calculated by simulation or experimentally to adjust the resonance frequency of each tank circuit (5) to the lower cut ($f_{pi}$) and the upper cut ($f_{ps}$) frequencies of the bandpass filter.

3. ANALOG BAND PASS FILTER according to Claim 1, **characterized in that** the control resistance $R_c$ has a value selectively calculated by a method selected from simulation and experimentally, in order to increase or diminish the effect of the tank circuits (5) on the filter response and to adjust the real response of the bandpass filter to the desired ideal response.

FIG.1

FIG.2

FIG.3

EP 1 453 196 A1

FIG.4

## INTERNATIONAL SEARCH REPORT

| International application No. |
| --- |
| PCT/ES02/00523 |

**A. CLASSIFICATION OF SUBJECT MATTER**

**IPC 7 :** H 03 H 7 / 075 , 7 / 03

According to International Patent Classification (IPC) or to both national classification and IPC

**B. FIELDS SEARCHED**

Minimum documentation searched (classification system followed by classification symbols)

**IPC 7 :** H 01 H 7 / 075 , 7 / 03 , 7 / 12 .

Documentation searched other than minimum documentation to the extent that such documents are included in the fields searched

Electronic data base consulted during the international search (name of data base and, where practicable, search terms used)

EPODOC, WIPL, PAJ, INSPEC , CIBEPAT.

**C. DOCUMENTS CONSIDERED TO BE RELEVANT**

| Category* | Citation of document, with indication, where appropriate, of the relevant passages | Relevant to claim No. |
| --- | --- | --- |
| A | US 6023205 A (HUANG ET AL.) 08.02.2000 ; the whole document | 1-3 |
| A | WO 0235716 A2 (BROADBAND INNOVATIONS , INC.) 02.05.2002 ; the whole document | 1-3 |
| A | US 6268766 B1 (THOMASSON) 31.07.2001 | |
| A | US 5148133 A (ZENNAMO , Jr. ET AL.) 15.09.1992 . | |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **17 December 2002 (17.12.02)** | **20 December 2002 (20.12.02)** |
| Name and mailing address of the ISA/ **S.P.T.O** | Authorized officer |
| Facsimile No. | Telephone No. |

Form PCT/ISA/210 (second sheet) (July 1992)

Form PCT/ISA/210 (patent family annex) (July 1992)

| Patent document cited in search report | Publication date | Patent familiy member(s) | Publication date |
|---|---|---|---|
| US 6023205 A | 08.02.2000 | WO 9938268 A<br>AU 2216299 A<br>EP 1051807 A<br>CN 1289483T T | 29.07.1999<br>09.08.1999<br>15.11.2000<br>28.03.2001 |
| WO 0235716 A | 02.05.2002 | NONE | ——— |
| US 6268766 B | 31.07.2001 | WO 0148924 A<br>EP 1260022 A | 05.07.2001<br>27.11.2002 |
| US 5148133 A | 15.09.1992 | CA 2069649 A<br>US 5168251 A<br>EP 05168251 A<br>JP 6029768 A | 30.11.1992<br>01.12.1992<br>02.12.1992<br>04.02.1994 |

**INTERNATIONAL SEARCH REPORT**
Information on patent family members

International Application No

PCT/ES02/00523